# EUROPEAN PATENT APPLICATION

(11) **EP 1 936 698 A1**
(43) Date of publication of application: **25.06.2008**
(21) Application number: 06380323.3
(22) Date of filing: 18.12.2006
(51) Int. Cl.: H01L 31/02, H01L 31/0224, H01L 31/068

(54) **Process for manufacturing photovoltaic cells**

(71) Applicant: BP Solar Espana, S.A. Unipersonal, 28760 Madrid (ES)
(72) Inventor: Russell, Richard W. J., 28750 Madrid (ES); Vincuenia, Ines, 28752 Madrid (ES); Bueno, Rafael M., 28860 Madrid (ES); Fernandez, Juan M., 28030 Madrid (ES); Narayanan, Srinivasamohan, Maryland 20878 (US)
(74) Representative: Hamer, Christopher K.

(57) **Abstract**

A process for making a photovoltaic cell comprising forming a first layer on a front surface of a semiconductor wafer, the wafer comprising a first dopant and the first layer comprising a dopant of a conductivity type opposite the first dopant; depositing a surface coating on the front surface over the first layer; forming grooves in the front surface after depositing the surface coating thereon; doping the grooves with a dopant having a conductivity opposite the first dopant; treating a back surface of the wafer to remove at least substantially all dopant having a conductivity type opposite the first dopant; forming a back surface field; forming a back electrical contact over the back surface; and adding an electrically conductive material to the grooves to form a front electrical contact.

## Description

### Background of the Invention

This invention relates to a process for manufacturing photovoltaic cells. More particularly, this invention relates to a process for manufacturing photovoltaic cells that are highly efficient in converting light energy, and particularly solar energy, to electrical energy. This invention also relates to photovoltaic cells that can be manufactured by such process. One of the most important features of a photovoltaic cell is its efficiency in converting light energy from the sun into electrical energy. Thus, the art is continuously striving to improve the efficiency of photovoltaic cells for converting light energy into electrical energy.

Typically, when used to convert solar energy into electrical energy, a plurality of photovoltaic cells are arranged in one or more panels or modules in order to generate an amount of power required for a desired commercial or consumer application. The modules can be conveniently handled for mounting on a building roof or other structure.

Photovoltaic cells, also referred to as solar cells, can be fabricated from a variety of semiconductor materials. Silicon, however, is generally used because it has the proper balance of electrical, physical and chemical properties for fabricating photovoltaic cells.

In a typical procedure for the manufacture of photovoltaic cells, using silicon as the selected semiconductor material, the silicon is doped with a dopant of either positive or negative conductivity type, formed into either single crystal ingots of silicon or blocks of what the art refers to as multicrystalline silicon, and these ingots or blocks are cut into thin substrates, also referred to as wafers, by various slicing or sawing methods known in the art. However, these are not the only methods used to obtain suitable semiconductor wafers for the manufacture of photovoltaic cells. The surface of the wafer intended to face incident light when the wafer is formed into a photovoltaic cell is referred to herein as the front face or front surface, and the surface of the wafer opposite the front face is referred to herein as the back or rear face, or back or rear surface. By convention, positive conductivity type is commonly designated as "p" or "p-type" and negative conductivity type is commonly designated as "n" or "n-type". In one method for manufacturing photovoltaic cells, a p-doped wafer is exposed to a suitable n-dopant to form an emitter layer and p-n junction. Typically, the n-doped layer or emitter layer is formed by first depositing the n-dopant onto the front surface of the p-doped wafer using techniques commonly employed in the art such as chemical vapor deposition or other deposition methods and, after such deposition, the n-dopant is driven into the surface of the silicon wafer to further diffuse the n-dopant into the wafer surface. This "drive-in" step is commonly accomplished by exposing the wafer to heat, often in combination with a gas stream comprising POCl₃ and oxygen. A p-n junction is thereby formed at the boundary region between the n-doped emitter layer and the p-doped silicon substrate. The wafer surface can be textured prior to forming the emitter layer.

In order to utilize the electrical potential generated by exposing the p-n junction to light energy, the photovoltaic cell is typically provided with a conductive front electrical contact and a conductive back or rear electrical contact. Such contacts are typically made of or contain one or more highly conducting metals and are, therefore, typically opaque. Since the front contact is on the side of the photovoltaic cell facing the sun or other source of light energy, it is generally desirable for the front contact to occupy the least amount of area of the front surface of the cell as possible yet still capture the electron charges generated by the incident light interacting with the cell. If the front contact is too large in area, the amount of shading caused by the opaque contact itself will reduce the amount of light impinging on the cell and result in the undesirable reduction of cell efficiency. However, it is still necessary for the front contact to be of sufficient area and to be properly positioned on the front surface of the cell so that it is able to efficiently capture the electron charges generated by the light radiation interacting with the doped silicon layers.

A number of methods have been developed in the art for applying front contacts to a crystalline silicon, multicrystalline silicon, or other semiconductor wafer. One known method is to form a buried contact. In the buried-type of front contact, the front contact is made by scribing or cutting a pattern of scribes or grooves into the surface of the wafer in an open grid pattern and thereafter filling the grooves with a conducting material such as a highly conducting metal. One suitable method for forming the grooves for the buried grid contact is to use a laser. Methods for forming buried-type contacts are described in, for example, U. S. Patent No. 4,726,850, to Wenham et al., which is incorporated herein by reference in its entirety.

An early method for making photovoltaic cells having buried-type front contacts follows a processing sequence as follows. The n-layer is created in a p-type crystalline or multicrystalline silicon wafer by diffusing phosphorus into the p-type wafer thereby forming an emitter layer and a p-n junction. A layer of a dielectric material is applied to the surface of the wafer having the p-n junction as an anti-reflective coating, for example, a layer of silicon nitride. This is, ultimately, the light receiving side of the cell. Using a laser, narrow and deep grooves are cut through the dielectric layer and into the silicon substrate in a pattern that will form the front buried contact. The grooves are etched with a chemical solution, such as sodium hydroxide, to remove damaged silicon and to clean the grooves. Additional phosphorous is diffused into the walls of the grooves. Such heavy doping of the surfaces within the grooves improves the efficiency of the cell. The back electrical contact is added to the cell, typically by one or more electrochemical plating techniques known to those of skill in the art. Prior to adding the back contact, a back surface field can be added to the wafer by heavily p-doping the back surface of the wafer. Such p-doping can be achieved by applying aluminum or boron to the back surface of the wafer followed by a high temperature sintering step. The grooves in the front of the cell are filled with a conductor, for example, one or more of silver, nickel, or copper, by one or more methods such as electrolytic or electroless plating, or using a metal-containing paste followed by firing the paste to form the metal contact. An edge isolation step separates any electrical connections between the front and back of the cell. A process for producing a photovoltaic cell having a buried front contact using, *inter alia,* processing steps in the sequence of silicon nitride coating of the front surface, laser grooving, sodium hydroxide etch, diffusion of grooves, applying back contact and firing, applying front contact and firing, and edge isolation, is disclosed in U. S. Patent No. 4,726,850 (disclosed as "Sequence B" therein), as being one which may yield a higher efficiency photovoltaic cell.

A more recently used method for making photovoltaic cells having buried-type front contacts follows a processing sequence as follows. The wafer is textured using one or more available methods for texturing the surfaces of a silicon wafer. The n-layer is created in a p- type crystalline silicon wafer by diffusing phosphorus into the p-type wafer thereby forming an emitter layer and a p-n junction. A layer of a dielectric material is applied to the surface of the wafer having the p-n junction as an anti-reflective coating, for example, a layer of silicon nitride. This is, ultimately, the light receiving side of the photovoltaic cell. Extraneous dielectric coating that may have been deposited on the rear surface is removed. As described above, a laser is then used to form narrow grooves through the dielectric layer and deep into the silicon substrate in a pattern that will form the front buried contact. The grooves are etched with a chemical solution, such as sodium hydroxide, to clean the grooves and remove damages silicon. After the groove etch, which also removes the texture from the back side of the wafer, additional phosphorous is diffused into the walls of the grooves. Such doping of the surfaces within the grooves improves the efficiency of the cell but also adds phosphorus to the back side of the wafer. The back contact is added to the cell, typically by one or more electrochemical plating techniques known to those of skill in the art. Prior to adding the back contact, a back surface field can be added to the wafer by heavily p-doping the back surface of the wafer. Such p-doping can be achieved by applying aluminum or boron to the back surface of the wafer followed by a high temperature sintering step. The grooves in the front of the cell are filled with a conductor, for example, one or more of silver, nickel, or copper, by one or more methods such as electrolytic or electroless plating, or using a paste followed by firing the paste to form the metal contact. An edge isolation step separates any electrical connections between the front and back of the cell. A process for producing a photovoltaic cell having a buried front contact using, *inter alia,* these processing steps is disclosed in PCT patent application WO 02/103810.

While such processing sequences result in an efficient, buried contact-type of photovoltaic cell, both processes result in the phosphorous doping of the rear surface of the cell.

As mentioned above, the art is continually striving to prepare photovoltaic cells, particularly cells that can be manufactured on a commercial production scale, that are higher in efficiency. For example, in the processes described above, the n-type dopant, such as phosphorus, applied to and diffused into the grooves cut into the wafer, also diffuses into the rear surface of the wafer thereby adversely affecting the formation of the back surface field and resulting in a reduction of the efficiency of the cell.

The art therefore needs a process to manufacture photovoltaic cells having improved efficiency where such process is applicable to commercial scale production. The present invention provides such process.

### Summary of the Invention

This invention is a process for making a photovoltaic cell comprising (a) forming a first layer on a front surface of a semiconductor wafer, the wafer comprising a first dopant and the first layer comprising a dopant of a conductivity type opposite the first dopant; (b) depositing a surface coating on the front surface over the first layer; (c) forming grooves in the front surface after depositing the surface coating thereon; (d) doping the grooves with a dopant having a conductivity opposite the first dopant; (e) treating a back surface of the wafer to remove all or substantially all dopant having a conductivity type opposite the first dopant; (f) forming a back surface field; (g) forming a back electrical contact over the back surface; and (h) adding an electrically conductive material to the grooves to form a front electrical contact.

This invention is also a photovoltaic cell comprising a wafer doped with a first dopant and having a front surface and a back surface, a buried grid electrical contact on the front surface, a back surface field, a back electrical contact, an emitter layer comprising a dopant of conductivity type opposite the first dopant, and where the back surface of the wafer, in the region of the back surface field is free of, or substantially free of, dopant of conductivity opposite the first dopant.

The photovoltaic cells made by the process of this invention can be used to convert solar energy into electric current.

### Brief Description of the Drawing

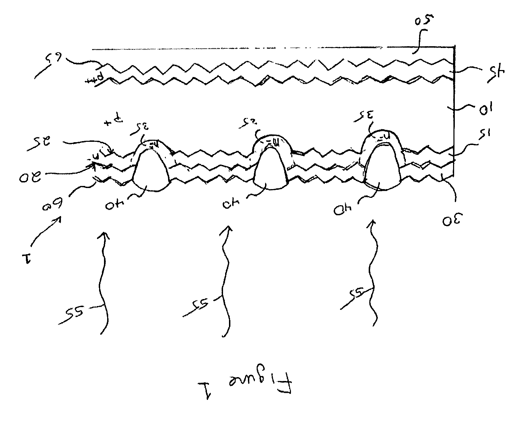

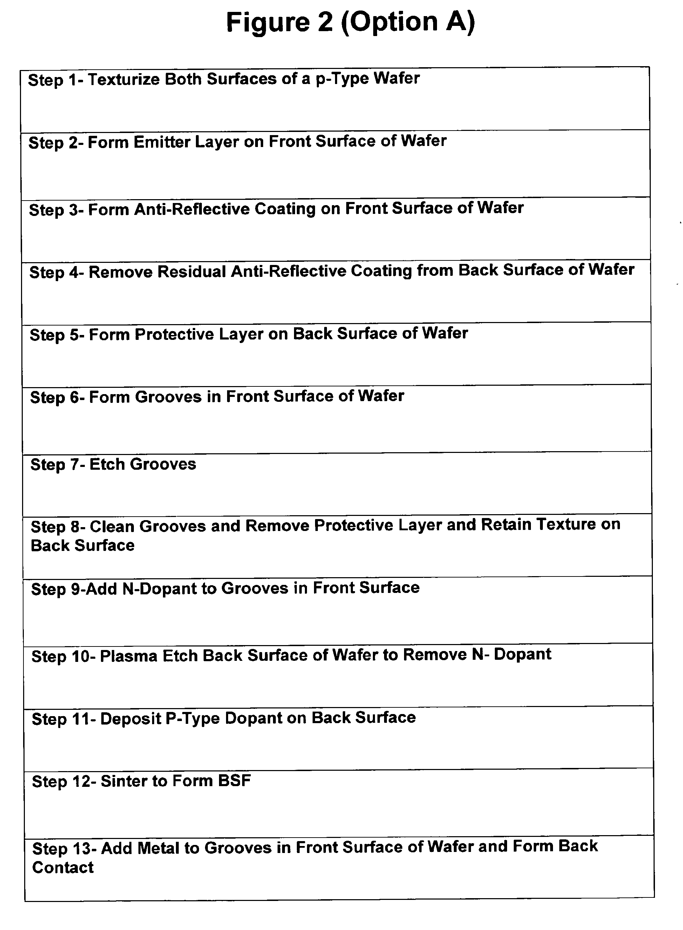

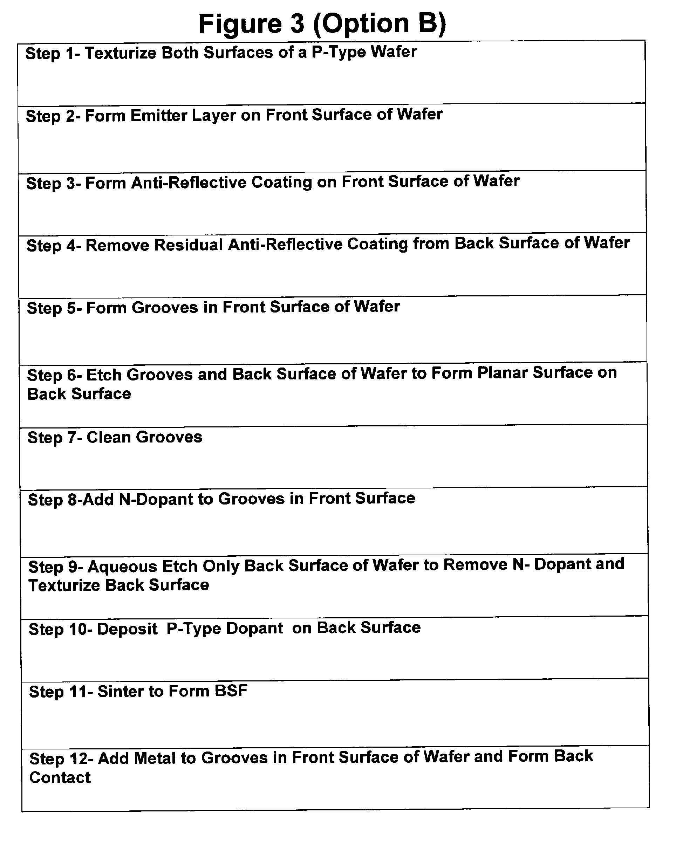

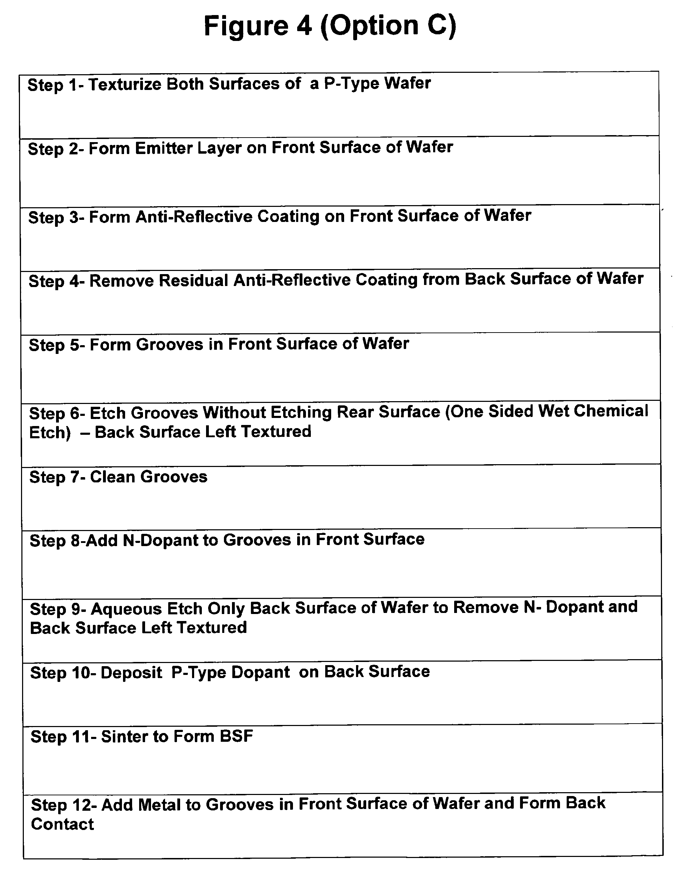

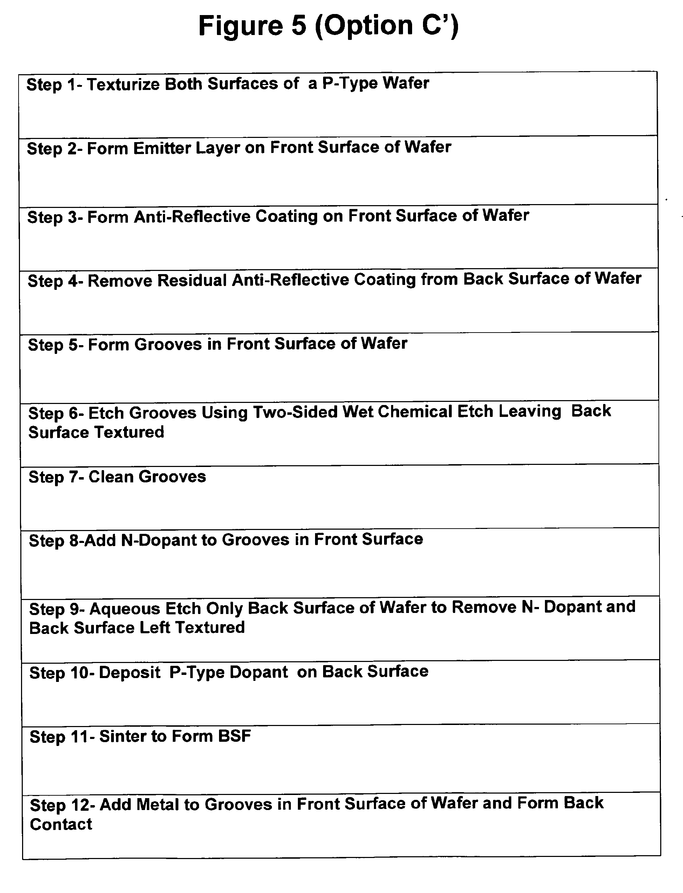

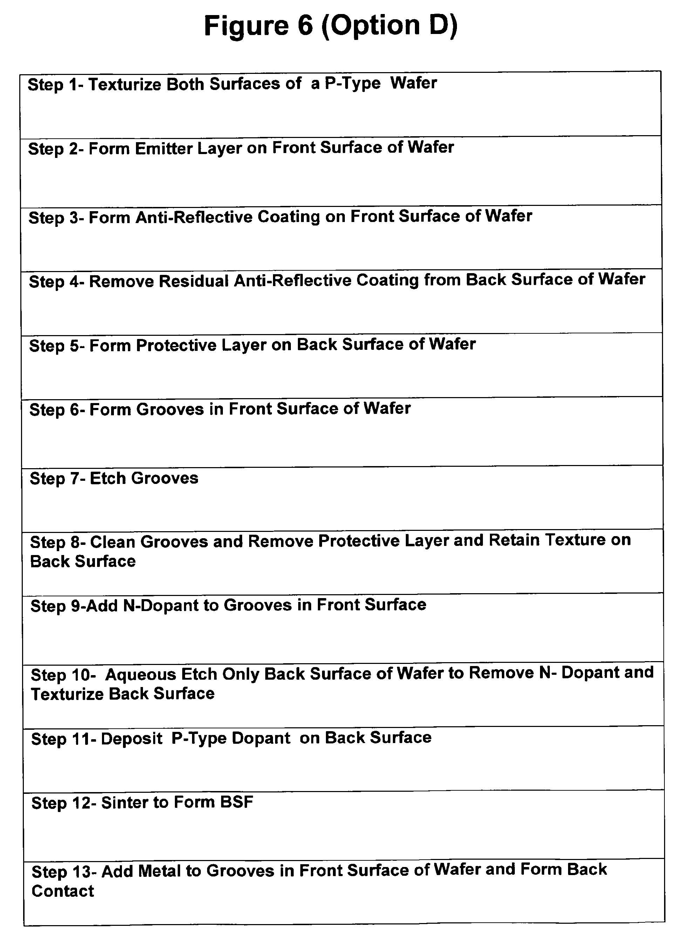

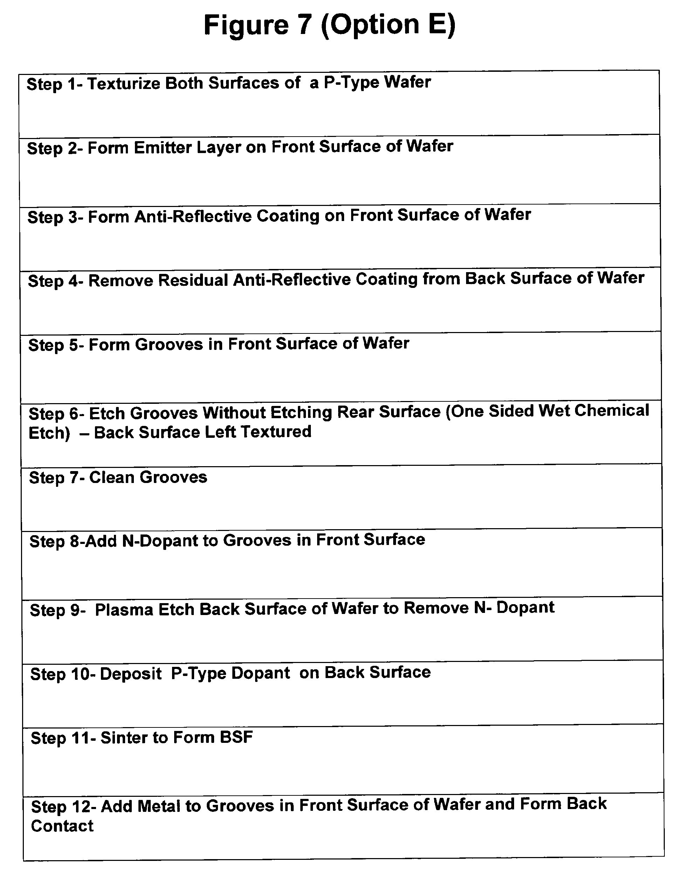

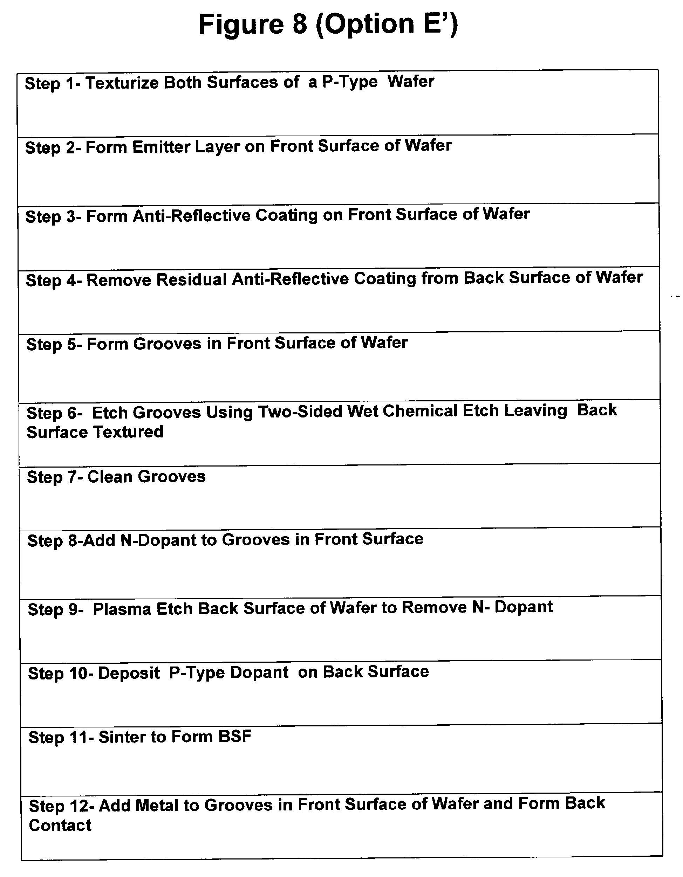

Figure 1 shows a cross-section of a part of a photovoltaic cell made in accordance with an embodiment of this invention.

### Detailed Description Of the Invention

The invention will now be described using as an example an embodiment of the invention whereby a photovoltaic cell is made using a p- doped silicon wafer. However, it is to be understood that the invention is not limited thereby and is, for example, applicable to other semiconductor materials, such as silicon wafers that are n-doped.

A p-doped silicon wafer useful in the process of this invention for preparing photovoltaic cells is typically in the form of thin, flat shape. Although boron is widely used as the p-type dopant, other p-type dopants, for example gallium or indium, will also suffice. Boron is a preferred p-type dopant. Combinations of such dopants are also suitable. Suitable wafers are typically obtained by slicing or sawing p-doped silicon ingots, such as single crystal ingots of mono-crystalline wafers, to form mono-crystalline wafers, such as so-called, Czochralski (Cz) silicon wafers. Suitable wafers can also be made by slicing or sawing blocks of cast, p-doped multi-crystalline silicon. Silicon wafers can also be pulled straight from molten silicon using processes such as Edge-defined Film-fed Growth technology (EFG) or similar techniques. Although the wafers can be any shape, wafers are typically circular, square or pseudo-square in shape, where "pseudo-square" means the wafer is predominantly square shape, usually with rounded corners. Thus, in general, wafers useful in this invention are flat, typically round, square or pseudo-square in shape and are thin. For example, a wafer useful in this invention can be at least about 50 microns thick, and can be up to about 400 microns thick. Usually, however, the wafers can be about 200 to about 300 microns thick. If circular they can have a diameter of about 102 to about 178 millimeters. If square or pseudo-square, they can have a width of about 100 millimeters to about 150 millimeters with rounded corners having a diameter of about 127 to about 178 millimeters. The wafers useful in the process of this invention, and consequently the photovoltaic cells made by the process of this invention, can have a surface area of about 140 to about 160 square centimeters. The doped wafers useful in the process of this invention can have a resistivity of about 0.1 to about 10 ohm.cm, typically of about 0.5 to about 2.0 ohm.cm. The wafers used to manufacture the photovoltaic cells of this invention are preferably made of p-doped, monocrystalline silicon. Suitable wafers used in the process of this invention are commercially available from, for example, Bayer Solar GmbH, PV Silicon GmbH, Pillar and other sources. Although the term wafer as used herein preferably means the wafers obtained by the methods described, particularly by the sawing or cutting of ingots or blocks of silicon, it is to be understood that the term wafer can also include any other suitable semiconductor substrate useful for preparing photovoltaic cells by the process of this invention.

The wafer can be textured, and can be textured by one or more texturing techniques that result in, for example, an anisotropically textured surface. Texture is added to increase the amount of light energy that enters the photovoltaic cell, thereby increasing its efficiency. The wafer can be suitably textured using chemical etching, plasma etching and mechanical scribing. A monocrystalline wafer can be conveniently etched to form an anisotropically textured surface by treating the wafer in an aqueous solution of a base, such as sodium hydroxide, at an elevated temperature, for example, about 70°C to about 90°C, for about, for example, 10 to about 120 minutes. The aqueous solution may contain an alcohol, such as isopropanol. Unless one side of the wafer is protected from exposure to the solution, such a procedure produces a textured surface on both surfaces of the wafer. The textured wafer is typically subsequently cleaned by immersion in hydrofluoric and thereafter with hydrochloric acid, with intermediate and final rinsing in de-ionized water, followed by drying. The texturing step is typically done prior to the formation of the emitter layer. A suitable textured surface for a wafer is in the form of random pyramids and, for example, where the distance between a valley between two such pyramids and the top of the pyramid is up to about 8 micrometers, such as from about 2 to about 8 micrometers.

An n-type dopant is applied to the wafer to produce an emitter layer and a p-n junction. Such n-doping can be accomplished by depositing the n-dopant onto the wafer and then heating the wafer to "drive" the n-dopant into the surface of the wafer. Gaseous diffusion can be used to deposit the n-dopant onto the wafer surface; however, other methods can also be used, such as ion implantation, solid source diffusion, or still other methods used in the art to create an n-doped layer and a p-n junction, usually proximal to the wafer surface. Phosphorus is a preferred n-dopant for a p-type wafer, but one or more other suitable n-dopants can be used. For example, one or more of phosphorus, arsenic, antimony or lithium can be used. If, for example, phosphorus is used as the dopant, it can be applied to the wafer using phosphorus oxychloride (POCl₃) or phosphorus containing pastes. In the process of this invention, the n-dopant can be added as phosphorus by subjecting the wafers to an atmosphere of phosphorus oxychloride and molecular oxygen at an elevated temperature of, for example, about 700°C to about 850°C, to deposit a layer of a phosphorus glass on the wafer. Such glass layer can be about 5 to about 20 nanometers thick, more typically from about 10 to about 15 nanometers. The n-dopant can be applied to--and thus the emitter layer formed on-- only one surface, the front surface, of the wafer. This can conveniently be accomplished by placing two wafers back-to-back when they are exposed to the material for adding the n-dopant thereby shielding the back surface form exposure to the dopant. Other methods for adding the n-dopant to only the front surface of the wafer can, however, be used, such as placing the wafers on a flat surface to shield the back surface of the wafer from being exposed to the dopant material. Even with such precautions to shield the back surface of the wafer, the back surface nevertheless receives some n-dopant. If an n-type wafer is used to manufacture photovoltaic cells in accordance with this invention, the emitter layer would be formed by applying a p-type dopant such as one or more of aluminum, boron or indium.

In a preferred process of this invention, the front surface of the wafer, preferably after texturing and forming the emitter layer as described above, is coated with a surface coating. The coating can be, for example, silicon nitride (SiN), silicon dioxide (SiO₂) or other suitable metal oxide. In the preferred embodiment of this invention, the surface coating applied to the front surface of the wafer is an anti-reflective coating. Such anti-reflective coating can be, for example, a layer of a dielectric such as tantalum oxide, silicon dioxide, titanium oxide, or silicon nitride, which can be added by methods known in the art such as, for example, plasma enhanced chemical vapor deposition (PECVD), low pressure chemical vapor deposition (LPCVD), thermal oxidation, screen printing of pastes, inks or sol gel, etc. Combinations of coatings, such as the coatings mentioned above, can also be used. The preferred anti-reflective coating for the buried contact type of solar cell is silicon nitride. The silicon nitride can be applied, for example, by PECVD. Preferably, the silicon nitride layer is applied using low pressure chemical vapor deposition (LPCVD). A common method for applying the silicon nitride by LPCVD is to expose the wafer to an atmosphere of suitable silicon compound, such as dichlorosilane, and ammonia at an elevated temperature of about 750°C to about 850°C.

At the time of application, an anti-reflective coating, such as silicon nitride, added to the front surface of the wafer is typically greater than about 100 nanometers thick and less than about 150 nanometers thick. The coating can be, for example, about 120 to about 140 nanometers thick. During subsequent process steps, the layer applied to the front surface, such as silicon nitride, will usually diminish in thickness. The front anti-reflective coating on the finished solar cell should be about 70 to about 100 nanometers thick.

Grooves are formed in the front surface of the wafer. These are the grooves that will become the front "buried" contacts after the grooves are metallized or otherwise filled with a conductor. The grooves are suitably cut or otherwise formed in the front surface of the wafer, all the way through the anti-reflective or other coating, if present, on the front surface. One or more mechanical methods, such as mechanical abrasion, or chemical methods, such as chemical etching, can be used to form the grooves. The grooves are, however, typically formed by laser scribing. A suitable laser is a Nd:YAG laser or Nd:YVO₄ laser, Q-switched at a frequency of about 10 to about 150 kHz. The laser can traverse the wafer surface at a velocity of about 100 to about 10,000 millimeters/second, for example at about 1000 millimeters/ second. A first set of grooves are suitably added to the front surface of the wafer in a pattern of parallel lines distributed over the entire front surface of the wafer. The grooves can be about 0.3 to about 2 millimeters apart and can be about 10 to about 40 micrometers in width, and about 10 to about 50 micrometers in depth. A second set of grooves is typically added perpendicular to and intersecting the first set of grooves. Such second set of grooves can be added as a "bundle" of grooves, or as two or more "bundles" of grooves. This second set of grooves can be arranged so that the grooves in each bundle are closely spaced, for example, about 10 to about 50 micrometers apart. There can be about 10 to about 20 grooves in each bundle. Thus, such bundle can be about 0.5 to about 1.5 millimeters wide. On a 125 millimeter, pseudo-square wafer, the bundles can be about 55 to about 65 millimeters apart from each other on the wafer. After metallization, as described in detail below, such bundle or bundles of grooves can function as bus bars that electrically connect the first set of grooves and can also function as contact points for electrical leads or cell-to-cell interconnects that are attached, such as by soldering, to the completed photovoltaic cell. U. S. Patent No. 4,726,850 to Wenham et al., as mentioned above, discloses methods for making grooves in silicon substrates for buried contacts.

The grooves are typically etched by one or more chemical etching techniques. For example the cutting or scribing process generally results in the formation of undesirable silicon debris in and around the grooves. Consequently, it is desirable to remove such debris. It is also desirable to further etch the grooves. The grooves can be etched by treating the wafer with an aqueous solution of base, such as sodium hydroxide, at a temperature of, for example, about 50°C to about 70°C, for a time sufficient to eliminate or reduce the silicon debris and to etch the walls of the grooves by a few, for example, about 1 to about 10 micrometers. After such etching procedure, the wafers can be cleaned by immersing the wafers in hydrofluoric acid and hydrochloric acid, with intermediate and final rinsing in de-ionized water. If the back surface of the wafer is not protected by, for example, a suitable coating, such as a coating that is inert to the etching solution described above or other etching solution, the etching solution will reduce or remove the texture from the back surface of the wafer. If an anti-reflective coating such as silicon nitride, or other anti-reflective coating, has been applied to the front surface, such coating will preclude the etchant from reducing or removing the texture on the front surface of wafer.

As will be described in more detail below, in one embodiment of this invention, texture on the back surface of the wafer is retained. One method for retaining a textured back surface is to protect the back surface from being etched by the etchant used to etch the grooves. Such protection can be conveniently achieved by depositing or otherwise forming a protective coating or layer over the rear surface prior to the step of etching the grooves. Any suitable protective coating or layer can be used. For example, it can be one or more of silicon dioxide or silicon nitride or other suitable material that resists etching, such as etching by aqueous sodium hydroxide. One suitable coating is a layer of silicon dioxide applied by wet oxidation. Such a layer can be applied by heating the silicon wafer at an elevated temperature, for example about 850°C to about 950°C, for about 30 to about 60 minutes, in the presence of water vapor. The protective layer, for example the layer of silicon dioxide, can be about 20 nanometers to about 100 nanometers thick, such as about 40 to about 60 nanometers thick. As described below, it is advantageous to remove the protective coating or layer prior to forming a back surface field on the rear surface of the wafer. Therefore, the type of material used to form the protective layer, and thickness of the protective coating or layer, should be such that it adequately protects the texture of the rear textured surface of the wafer, but can later be removed before forming a back surface field. A silicon dioxide protective layer about 40 to about 60 nanometers thick and deposited by wet oxidation protects the textured, rear surface of the wafer, and can later be removed by the cleaning procedure used to clean the grooves. Thus, the cleaning treatment described above using hydrofluoric acid and hydrochloric acid, with intermediate and final rinsing in de-ionized water, can be used to remove such layer of silicon dioxide while retaining the texture on the back surface of the wafer. An alternate way to retain a textured back surface is to prevent the etchant solution used to etch the grooves from contacting the back surface. This can be accomplished by, for example, a single sided etching techniques such as transporting the wafers horizontally on rollers just above an etching solution such that the etching solution is transferred to only one side of the wafer thus achieving single sided etching. Another way to retain a textured back surface is to treat the back surface to reform the texture removed by the groove etching step. If the back surface is not protected from exposure to the solution used to etch the grooves by, for example, a layer of inert material, or if it is not otherwise protected from exposure to such etching solution, the texture on the back surface originally produced by the wafer texturing step will be reduced or removed. If all or substantially all of the texture is removed the back surface will be flat or planar. In such case, the texture on back surface can be again applied by, for example, treating the back surface with one or more of the procedures described above used to form the original texture, such as one or more of chemical etching, plasma etching, or mechanical scribing.

The grooves, typically after the preferred etching, cleaning and washing procedures, are doped to add additional n-dopant to the grooves. As described above for the formation of the emitter layer and p-n junction, the same dopants and doping procedures can be used. However, in the preferred process of this invention the grooves are further doped using phosphorus oxychloride (POCl₃). For example, the wafers can be treated in an atmosphere of phosphorus oxychloride and molecular oxygen at a molar ratio of about 3:1, respectively, and at a temperature of about 800 °C to about 1000°C to dope the exposed silicon surfaces in the grooves on the front surface of the wafer. After such doping, the groove surfaces preferably have a sheet resistivity of about 5 to about 15 ohm/square. This doping procedure is preferably conducted in a manner so that the rear surface of the wafer also receives the p-dopant.

We determined that the groove doping conditions can affect the bulk minority lifetimes of the silicon in the doped grooves. For example, typical bulk minority lifetimes before groove doping may be in the range of about 10 to about 15 microseconds (µsec) for a standard, 1 ohm.cm, Cz, boron doped wafer. However, in accordance with this invention, bulk minority lifetimes of greater than 15 µsec have been achieved, for example, bulk minority lifetimes of at least about 20, or at least about 50 µsec have been achieved. Bulk minority lifetimes of at least about 100 µsec have been achieved. Control of deposition time and deposition temperature led to the greatest enhancement of bulk minority lifetime. For example, using deposition temperatures of about 920°C to about 980°C, or about 940°C to about 980°C, and deposition times of about 30minutes to about 50 minutes, resulted in the highest bulk minority lifetimes using a mixture of phosphorus oxychloride and molecular oxygen to form a layer of P₂O₅.

The bulk minority lifetimes of the doped grooves can be measured after removing the silicon nitride layer (or other layer used on the front surface), etching in aqueous sodium hydroxide to remove the diffused n-layers, cleaning with aqueous hydrogen fluoride then aqueous hydrogen chloride, and then passivating the surfaces with a mixture of iodine in ethanol. The bulk lifetimes can be measure by, for example, using microwave photoconductance decay techniques are known to those of skill in the art..

Prior to adding a back electrical contact and optional back surface field, the silicon wafer is treated to remove all or substantially all of the n-dopant on the back surface that may have been deposited there during one or both of the n-dopant deposition steps. Preferably, the back surface of the wafer is treated to remove all or substantially all of the n-dopant so that, for a p-type wafer, the back surface registers as p-type when measured using standard procedures, such as by using a "wafer probe," for measuring the conductivity of silicon wafers. Preferably, the back surface is treated to remove all or substantially all of the n-dopant so that sheet resistivity of the wafer measured at the back surface is at least about 30, or at least about 40 ohms/sq.

We determined that the treatment of the back surface to remove the n-dopant results in an improved photovoltaic cell, for example, a cell having a higher efficiency for converting light to electrical current.

Any suitable method can be used to remove the n-dopant from the back surface of the wafer. For example, the back surface of the wafer can be etched to remove the layer of silicon containing the n-dopant. Such etching can be accomplished by chemical etching using, for example, the aqueous solution described above for etching the grooves. It can also be removed by plasma etching. In one suitable method for plasma etching the back side of the silicon wafer to remove n-dopant, the back surface of the wafer is exposed to a gas plasma formed with, for example, a mixture of a halocarbon (for example, C₂F₆ or CF₄) and molecular oxygen. Such plasma etching procedures are known in the art. In order to etch only the back surface, some step should be taken to shield the front surface. This can be accomplished by, for example, placing two wafers with their front surfaces facing and pressed against each other. In that way, the front surface is protected from exposure to the plasma. Another method is to place the wafer with its front surface on a suitable tray or plate, such as a plate of glass or tray with a suitable recess, so that the front surface is protected during the step to remove the n-layer from the back surface of the wafer.

The back surface of the wafer is etched to remove most or substantially all of the n-dopant present. The back surface can be treated to remove all of the n-dopant. The back surface can, for example, be treated by one or more of the methods described above. We determined that when back surface is treated to remove all or substantially all of the n-dopant, and the back surface field is thereafter formed, the performance of the photovoltaic cell using such wafer is improved. Removal of all or substantially all of the n-dopant from the back surface of the wafer can improve photovoltaic cell performance by at least about 3 percent, for example, at least about 4 percent.

The process of this invention preferably includes the formation of a back surface field (BSF) to increase the efficiency of the photovoltaic cell. A BSF can be generated by forming a p++ layer in the back surface of the p-type wafer. A p++ layer is a layer heavily doped with a p-type substance. Heavily doped means, preferably, that the concentration or level of dopant in the p++ layer or BSF is substantially greater than the concentration or level of p-dopant in the rest of the body of the p-type wafer. For example, the concentration of dopant in a BSF layer in an embodiment of this invention can be about 10 to about 1000, or 10 to about 100 times the concentration of p- dopant present in the body of the silicon wafer. The BSF layer is advantageously formed by alloying a substance into the back surface of the silicon substrate. Aluminum is typically used, but any substance can be used which is capable of alloying with the silicon and resulting in a p++ BSF layer. In one suitable procedure, aluminum, or other alloying substance such as, for example, boron, gallium or indium, or a combination of one or more thereof, is first deposited onto the back surface of the substrate. The aluminum or other alloying p-type substance can be applied using a screen printing technique or it can be applied by some other method known the art such as one or more sputtering techniques. The wafer is thereafter fired at a temperature sufficient to alloy the aluminum or other p-type substance, as mentioned above, into the silicon wafer substrate thereby creating a back surface field. Such a temperature can be about 900°C to about 1100 °C. The firing or sintering suitably takes place in an atmosphere comprising molecular oxygen, for example, and atmosphere comprising molecular oxygen and molecular nitrogen gas.

In one embodiment of this invention to form a BSF, an aluminum layer is applied to the back surface by magnetron sputtering. The aluminum layer can be applied to a thickness of about 0.2 to about 3.0 microns, for example, about 1 to about 2 microns. Thereafter, the wafer is fired at an elevated temperature, for example, at a temperature of about 900°C to about 1050°C, for about 10 to about 60 minutes, preferably in an atmosphere containing molecular oxygen, such as an atmosphere of molecular oxygen mixed with molecular nitrogen gas.

In order to complete the formation of the front, buried contacts, the grooves are filled with a conductive material. The conductive material is preferably one or more highly conductive metals such as silver, nickel, tin, copper, gold, platinum or other highly conductive metal. The grooves can be filled with such metal by one or more techniques known to those of skill in the art such as by filling grooves with a paste containing a metal by, for example, using a squeegee to press paste into the grooves, and thereafter heating the wafer to an elevated temperature and for a time to convert the paste into a metal conductor. The metal can be added to the grooves by one or more electroplating techniques known to those of skill in the art such as, for example, electrolytic or electroless plating. In one embodiment of this invention, the grooves are filled with a conducting metal by first immersing the wafer in a solution of hydrofluoric acid and then rinsing in de-ionized water. This treatment removes any phosphorus glass that may have formed in the grooves as a result of the groove doping step along with any undesirable impurities that may have collected in such glass. The wafers are then immersed in commercially available electroless nickel plating solution to deposit a layer of nickel such as, for example, a layer about 0.05 to about 0. 2 micrometers thick, followed by a rinse in de-ionized water and drying. The wafers are then heated to a temperature of about 350°C to about 450°C for about 5 to about 20 minutes to sinter the nickel. The wafers are then treated to apply a layer of copper to the nickel. The layer of copper can be about 2 to about 10 micrometers in thickness. In such a treatment the wafer is immersed in nitric acid and then rinsed with water, then immersed in hydrofluoric acid, and then rinsed in water, then immersed in commercially available electroless nickel plating solution, then rinsed in water, then immersed in commercially available electroless copper plating solution, then rinsed in water, then immersed in a silver potassium cyanide solution and then rinsed in water and dried. Such procedure applies a conductive copper layer to the grooves and to the back surface at the same time thereby completing the back and front contact. It is not, however, necessary to apply the conductive metal to the grooves on the front surface of the wafer and to the back surface of the wafer at the same time. It is, however, convenient to use the above-described electroless method for applying the conductive metals to apply both the front and back electrical contacts at the same time using the same process steps and chemical solutions. The back electrical contact can be applied separately by, for example, deposition of a layer comprising one or more conductive metals such as silver, aluminum, copper, tin, gold, platinum, cobalt and the like, to the back surface by one or more methods known in the art such as by sputtering or vaporization. Methods for filling the grooves with a conductive metal are also disclosed in European Patent Application Publication Number 1182709, Jensen et al., published on February 27, 2002, which is incorporated herein by reference.

If desired, photovoltaic cells made by the process just described can be edge isolated by, for example, laser scribing around the front or rear surface at or very near the edge of the cell and then, preferably, physically breaking off the edge of the cell to electrically separate the front and back sides of the cell from each other. Other methods for edge isolation can also be used such as mechanically grinding or cutting off the edge of the cell.

The photovoltaic cells of this invention have high efficiency in converting light energy into electrical energy. Photovoltaic cells of this invention made using a silicon wafer have an efficiency of at least about 18 percent, more preferably at least about 18.3 percent, and still more preferable can have an efficiency of at least about 18.6. Photovoltaic cells of this invention made using a silicon wafer, for example, a monocrystalline silicon wafer made by the float zone method, can have an efficiency of at least about 19 percent. The photovoltaic cells of this invention can be made having an efficiency of at least about 18 percent or at least about 18.3 percent or 18.6 percent using silicon wafers, such as Cz wafers, where the wafers have low levels of oxygen atoms and low levels of carbon atoms. Thus, the photovoltaic cells of this invention can be made having an efficiency of at least about 18 percent, or at least about 18.3 percent or 18.6 percent using silicon wafers having less than about 8 x 10¹⁷ atoms per cubic centimeter of the silicon wafer, or not more than about 5 x 10¹⁷ (for example, about 3 x 10¹⁷) oxygen atoms per cubic centimeter of the silicon wafer, and less than about 5 x 10¹⁶, or not more than about 4 x 10¹⁶ (for example, about 3 x 10¹⁶) carbon atoms per cubic centimeter of the silicon wafer. The preferred wafer used for the photovoltaic cells of this invention is a monocrystalline Cz silicon wafer. As used herein, the efficiency of the solar cells made by the process of this invention is measured using the standard test conditions of AM1.5G at 25°C using 1000 W/m² (1000 watts per square meter) illumination where the efficiency is the electrical energy output of the cell over the light energy input, expressed as a percent.

Figure 1 shows a cross-section of a part of photovoltaic cell 1 made in accordance with an embodiment of the process of this invention. The photovoltaic cell 1 of Fig. 1 has a boron, p-doped, monocrystalline silicon (Cz type) wafer 10. An n-doped layer 15, formed by phosphorus diffusion, is present next to the front surface 20 of silicon wafer 10. A p-n junction represented by line 25 is present where the boron doped substrate 10 meets the n-doped layer 15. Silicon nitride coating 30 has been applied over the n-doped emitter layer 15. Heavily doped n-layer 35 is under each buried contact 40. The back surface field layer 45 is within the silicon substrate 10 and adjacent to back metal contact 50. Back surface field layer 45 has no or substantially no n-dopant because any n-dopant was removed by an etching step prior to formation of back surface field 45 and application of back metal contact 50. Cell segment 1 is shown receiving incident solar radiation 55 on light receiving, front face 20. As depicted by the jagged lines in Figure 1, front surface 60 of solar cell 1 and back surface 65 of wafer 10 are textured.

Table 3 through 9 (annexed hereto) show processing steps for seven embodiments of this invention.

As show in Table 3, a first embodiment of this invention starts, as shown in Step1, by texturing both sides of a suitable silicon wafer, such as a p-doped, monocrystalline Cz wafer. Such texturing can be accomplished using, for example, a solution of sodium hydroxide and propanol at a temperature of 85 °C until the desired texture is achieved, and then cleaning the wafer by subsequent immersions in hydrofluoric acid and hydrochloric acid with intermediate and final rinsing in de-ionized water, followed by drying.

In Step 2, the emitter layer is formed by, for example, placing the wafers in pairs (touching) within slots in a quartz wafer carrier and then treating in an atmosphere of POCl₃ vapor and molecular oxygen at a temperature of 780°C to deposit a 10 nanometer thick film of phosphorus glass on the exposed surfaces of the wafer. Even though the wafers are touching, the back surfaces that were touching each other nevertheless received some phosphorus from this doping step.

In Step 3, the wafers are treated to form an anti-reflective coating on the front surface by, for example, exposing the wafers to an atmosphere of dichlorosilane and ammonia gases at a pressure of about 40 Pa (0.3 Torr) and a temperature between 780°C and 860°C, to deposit a 135 nanometers thick film of silicon nitride on the front surface of the silicon wafer. When conducting the step to deposit the silicon nitride, the wafers are placed in quartz holders so that the back surface is shielded from exposure to the reagents used to deposit the silicon nitride. For example, a quartz holder can be used to shield the back surface.

In Step 4, residual anti-reflective coating is removed from the back surface by, for example, etching in a gas plasma formed with a Freon and oxygen. This can be achieved by placing the wafers with their front surfaces touching each other and exposing the rear surfaces to the gas plasma or by placing the wafers with the front surface facing down on a glass plate.

In Step 5, a layer of protective material such as silicon dioxide is formed on the back surface by, for example, wet oxidation. Such layer can be about 50 nanometers thick.

In Step 6, a number of grooves are cut into the front surface (the surface with the silicon nitride layer) that will subsequently form the buried, front electrical contact for the completed photovoltaic cell. Each groove can have a dimension of 20 micrometers in width and 40 micrometers in depth and can be formed by, for example, laser ablation of the surface material using a Nd:YAG laser Q-switched at a frequency of 50kHz and traversing the wafer surface with a velocity of 500 millimeters/second. The groove pattern can be a first group of parallel lines 1.5 millimeters apart distributed over the entire wafer surface, and a second group of grooves can be perpendicular to the first group and joined in two bundles with a distance of about 6 centimeters between each bundle. Each bundle can have16 parallel grooves within a bundle width of 1.5 millimeters.

In Step 7, the grooves are etched by, for example, treating them with an aqueous solution of sodium hydroxide at 64°C to dissolve the silicon debris and etch the groove walls to a depth of a few microns. The protective coating on the back surface of the wafer protects the texturing on the back surface so the texture is not removed by the etching.

In Step 8, the grooves are cleaned by, for example, subsequent immersions in hydrofluoric acid and hydrochloric acid with intermediate and final rinsing in de-ionized water followed by drying. This step also removes the silicon dioxide coating from the back surface of the wafer, leaving the back surface textured.

In Step 9, the grooves are heavily doped with a dopant of the same conductivity type as dopant used to form the emitter layer by, for example, inserting the wafers into a quartz tube and treating them in an atmosphere of POCl₃ vapor and molecular oxygen gas at a temperature of 950 °C-990 °C for 10 to 50 minutes to dope phosphorus into the exposed silicon surface to a sheet resistivity of, for example, about 8 ohm/square. During this step, both the front and back surfaces of the wafer are exposed to the dopant source.

In Step 10, the back surface of the wafer is treated to remove all or substantially all of the n-dopant added to the back surface in Steps 2 and 9. The n-dopant can be removed, by for example, a plasma etch using a plasma formed from a mixture of molecular oxygen gas and carbon tetrafluoride. Such an etching procedure will remove the layer of silicon containing the n-dopant, but leave the texture on the back surface.

In Step 11, a p-type dopant is added to the back surface by, for example, depositing a 2 micron thick layer of aluminum onto the back surface using a magnetron sputtering apparatus.

In Step 12, a back surface field is formed by, for example, sintering the aluminum layer deposited in Step 11. Such sintering can be accomplished by placing the wafers in a quartz wafer carrier and heating them in a quartz tube in a mixture of molecular oxygen and molecular nitrogen, and heating for about 30minutes at a temperature of 900 °C to 1100 °C.

In Step 13, the front grooves are filled with highly conducting metal and the back surface is coated with highly conducting metal to form the front and back electrical contacts, respectively. Such metal can be added to the grooves and the back surface of the wafer by immersing the wafers in a solution of hydrofluoric acid and rinsing in de-ionized water, then immersing them in an alkaline electroless nickel plating solution to deposit a 0.1 micrometer nickel film followed by a rinse in de-ionized water before drying. The nickel-plated wafers are heated to a temperature of 400ºC in a nitrogen atmosphere to sinter the nickel into the silicon surface. The wafers are then immersed in nitric acid, followed by a rinse in water, a second immersion in hydrofluoric acid, a rinse in water, an immersion in an acid electroless nickel solution, a rinse in water, a immersion in electroless copper solution, a rinse in water, immersion in a solution of silver potassium cyanide, and a rinse in water and then dried.

As shown in Table 4, a second embodiment of this invention has the same Steps 1-4 as the first embodiment shown in Table 3 and can be performed in the same manner described. In Step 5, a number of grooves are cut into the front surface (the surface with the silicon nitride film). The procedure described for Step 6 of Table 3 can be used to form such grooves.

In Step 6, the grooves are etched by, for example, the same procedure used in Step 7 in Table 3. However, since there is no protective coating on the back surface, the back surface is also etched which will reduce or eliminate the texture on the back surface of the wafer.

In Step 7, the grooves are cleaned. The procedure for cleaning the groves can be the same procedure as described for Step 8 in Table 3.

In Step 8, the groves are heavily doped. The procedure for doping the grooves can be the same procedure as described in Step 9 in Table 3.

In Step 9, the back surface of the wafer is etched with an aqueous etching solution to remove the n-dopant and to texturize the back surface. This can be accomplished by, for example, using an aqueous etching solution to etch only the back surface. One method for completing such one-sided etch is to transport the wafers on rollers just above the surface of the etching liquid. The rollers transport liquid to the rear surface only so only the rear is etched.

Steps 10 through 12 of Table 4 are the same as Steps 11 through 13 in Table 3 and can be accomplished in the same manner as described for Table 3.

As shown in Table 5, a third embodiment of this invention has the same process steps 1 through 12 as shown in Table 4 and can be completed in the same manner except that in Step 6 of Table 5 the front grooves are etched without etching the rear surface and, therefore, the back surface remains textured. This can be accomplished by, for example, by single sided etching as described above.

As shown in Table 6 a fourth embodiment of this invention has the same process steps 1 through 12 as shown in Table 5 and can be completed in the same manner except that in Step 6 the grooves are etched using an aqueous etch and where both the front surface and the back surfaces of the wafer are exposed to the aqueous etching solution, and etching conditions are used that leave a texture on the back surface. Such etching procedure can be accomplished by, for example, using conditions that are similar to those described above for texturing the wafer.

As shown in Table 7, a fifth embodiment of this invention has the same process steps 1 through 13 as shown in Table 3 and can be completed in the same manner except that in Step 10 an aqueous etch of the back surface is used instead of a plasma etch. The etch is accomplished so that only the back surface and not the front surface is etched with the aqueous etch. This can be accomplished by, for example, single sided etching techniques as described above.

As shown in Table 8, a sixth embodiment of this invention has the same process steps 1 through 12 as shown in Table 5 and can be completed in the same manner except that in Step 9 the back surface is etched to remove the n-dope layer using a plasma. The plasma etch can be accomplished using the same procedure as described for Step 10 in Table 3.

As shown in Table 9 a seventh embodiment of this invention has the same process steps 1 through 12 as shown in Table 8 and can be completed in the same manner except that in Step 6 the grooves are etched using an aqueous etch and where both the front surface and the back surface of the wafer is exposed to the aqueous etching solution except that the etching conditions are used that leave a texture on the back surface. Such etching procedure can be accomplished by, for example, using conditions that are similar to those described above for texturing the wafer.

The advantageous efficiency of the photovoltaic cells of this invention is demonstrated by the following examples. It is to be understood that such examples are provided to exemplify the invention and are not in any way intended to, or be construed to, limit the scope of the invention.

### Examples 1 and 2 of the Invention

Examples 1 and 2 describe making photovoltaic cells in accordance with two embodiments of this invention.

### 1. Starting Material

The silicon wafers used were conventional Cz silicon wafers doped p-type with boron to a resistivity of 1.2 ohm.cm and grown with [100] crystal planes parallel to the wafer surface. The wafer dimensions were 127 millimeters square with rounded corners of a diameter 165 millimeters, and had a area of 154.3 cm². The wafer thickness was 300 micrometers. Such wafers are commercially available, for example, from Bayer Solar GmbH, PV Silicon GmbH or Pillar.

### 2. Wafer Surface Preparation

The wafers were anisotropically "texture" etched in a solution of sodium hydroxide and propanol at a temperature of 85°C and cleaned by subsequent immersions in hydrofluoric acid and hydrochloric acid with intermediate and final rinsing in de-ionized water followed by drying.

### 3. Phosphorus Doping

Wafers were placed in pairs (touching) in the slots in a quartz wafer carrier and treated in an atmosphere of POCl₃ vapor and oxygen at a temperature of 780°C to deposit a 10 nanometer thick film of phosphorus glass on the exterior surfaces.

### 4. Silicon Nitride Deposition

The wafers were treated in an atmosphere of silicon nitride and ammonia gases at a pressure of 40 Pa and a temperature between 780°C and 860°C to deposit a 135 nanometers thick film of silicon nitride on the front with some ingress on the back surfaces of the silicon wafer.

### 5. Rear Plasma Etch

The silicon nitride layer on the back surface of the wafer was removed by etching in a gas plasma formed with Freon and molecular oxygen. This was achieved by placing the wafers with their front surfaces touching each other and exposing the rear surfaces to the gas plasma or by placing the wafers with the front side facing down on a glass plate.

### 6. Wet Oxidation

In Example 1 of the invention, a silicon dioxide layer 50 nanometers thick was deposited on the rear of the wafers by the process of wet oxidation in a tube furnace at a temperature of between 880°C and 920°C for 20 minutes in a water vapor ambient.

### 7. Laser Grooving

A number of grooves were cut into the front surface (the surface with the silicon nitride film). Each groove had dimensions of, typically, 20 micrometers in width and 40 micrometers in depth and, were formed by laser ablation of the surface material using a Nd:YAG laser Q-switched at a frequency of 50kHz and traversing the wafer surface with a velocity of 500 millimeters/second. The groove pattern had a first group of parallel lines 1.5 millimeters apart distributed over the entire wafer surface, and a second group of grooves perpendicular to the first group and joined in two bundles with a distance of about 6 centimeters between each bundle. Each bundle had parallel grooves within a bundle width of 1.5 millimeters.

### 8. Groove Cleaning

The action of laser grooving generally results in silicon debris on the wafer surface and groove sidewalls that contain undesirable crystal imperfections.

In Example 1, the wafers were etched in a solution of sodium hydroxide at 64°C to dissolve the silicon debris and etch the groove walls to a depth of a few microns. During this etching process the rear of the wafer was not etched due to the silicon dioxide barrier layer and, therefore, remained textured. The wafers were then cleaned by subsequent immersions in hydrofluoric acid and hydrochloric acid with intermediate and final rinsing in de-ionized water followed by drying.

In Example 2, the wafers were etched in a solution of sodium hydroxide and propanol at a temperature of 85°C to dissolve the silicon debris and etch the groove walls to a depth of a few microns. During this etching process the rear of the wafer remained textured etched. The wafers were then cleaned by subsequent immersions in hydrofluoric acid and hydrochloric acid with intermediate and final rinsing in de-ionized water followed by drying.

### 9. Groove Doping

The silicon wafers were placed in a quartz wafer carrier, inserted into a quartz tube and treated in an atmosphere of POCl₃ vapor and molecular oxygen at a temperature of 950°C-1000°C for 15 to 30 minutes to dope phosphorus into the exposed silicon surfaces to a sheet resistivity of about 8 ohm/square. The back surface of the wafer was not shielded from the POCl₃ vapor and molecular oxygen and therefore received the same doping.

### 10. Rear Plasma Etch

The n-type layer on the back surface of the wafer was removed by etching in a gas plasma formed with Freon and oxygen. This was achieved by placing the wafers with their front surfaces touching each other and exposing the rear surfaces to the gas plasma or by placing the wafers with the front side facing down on a glass plate.

### 11. Aluminum Deposition

A 1 -2 micrometer thick film of aluminum was deposited on the rear wafer surface by sputtering.

### 12. Aluminum Sintering

The silicon wafers were placed in a quartz wafer carrier that was inserted into a quartz tube in a mixture of molecular oxygen and nitrogen and heated for about 30 minutes at 900°C to 1100°C.

### 13. Nickel Plating

The wafers were immersed in a solution of 4% hydrofluoric acid for 90 seconds and rinsed in de-ionized water. The wafers were then immersed in an alkaline electroless nickel plating solution (Enplate Al-100) for 100 seconds to deposit a 0.1 micrometer nickel film, followed by a rinse in de-ionized water before drying.

### 14. Nickel Sintering

The nickel-plated wafers were heated to a temperature of 400°C for 6 minutes in a nitrogen atmosphere to sinter the nickel into the silicon surface.

### 15. Copper Plating

Wafers were treated using the following procedure to apply a 5 micron thick film of copper in the grooves and on to the rear surface of the wafer. A 2 minute immersion in 30% nitric acid was followed by a 10 minute rinse in water, a 30 second immersion in 1% hydrofluoric acid, a 10 minute rinse in water, a 60 second immersion in an acid electroless nickel solution (Enplate Ni-416) at a temperature of 90°C, a 30 second rinse in water, a 120 minute immersion in electroless copper solution (Enplate Cu-703) at a temperature of 50°C, a 10 minute rinse in water, a 6 minute immersion in a solution of silver potassium cyanide at room temperature, and a 10 minute rinse in water followed by drying.

### 16. Edge Isolation

The undesired electrically conductive deposits of nickel and copper on the edges were removed by cutting a groove to a depth of 100-150 micrometers into the silicon surface on the rear of the wafer and around the perimeter at a distance of 1 millimeter from the wafer edge. Cleaving and discarding the 1 millimeter silicon at the edge then removed the edge material.

### Comparative Example 3

For Example 3, the comparative example, photovoltaic cells were made using the same wafers and processed in parallel as the wafers for Examples 1 and 2 in such a way that the rear was left n-type and planar. The wafer surface preparation, phosphorus doping, silicon nitride deposition, plasma rear etch, wet oxidation (Although it was not necessary to include the wet oxidation to form the silicon dioxide layer, the silicon dioxide layer was formed in this comparative Example 3 so that the wafers used in Examples 1, 2 and 3 had the same thermal history) and laser grooving was identical as for Examples 1 and 2. The rear silicon dioxide layer formed in Example 3 wafers was removed by treatment with aqueous hydrogen fluoride before groove cleaning, groove doping, (There was no rear plasma etch so the back surface remained n-type.) aluminum deposition, aluminum sintering, nickel plating. nickel sintering, copper plating and edge isolation, as for Examples 1 and 2 of the invention.

Table 1 below reports the short circuit current, open circuit voltage, fill factor and cell efficiency for the best cell produced from groups of cells processed according to Examples 1, 2, and comparative Example 3. These data show that a photovoltaic cell produced in accordance with an embodiment of this invention where the n-dopant was removed from the back surface before forming the back surface field, and where the back surface was textured, produced a cell with improved performance compared to a cell formed without removing the n-dopant from the back surface and where the back surface was planar. The photovoltaic cells made in accordance with Examples 1 and 2 demonstrated a 4 percent and 2.8 percent increase in efficiency, respectively, relative to the photovoltaic cell made in accordance with comparative Example 3.

**TABLE 1**

| | **Material** | **Area [cm²]** | **Jsc [mA/cm²]** | **Voc [mV]** | **FF [%]** | **Efficiency [%]** |
|---|---|---|---|---|---|---|
| Example 1 | Cz wafer | 154.3 | 36.2 | 628 | 80.5 | 18.3 |
| Example 2 | Cz wafer | 138 | 36.1 | 628 | 79.9 | 18.1 |
| Example 3 (comparison) | Cz wafer | 154.3 | 35.2 | 619 | 80.7 | 17.6 |

| | | | | | | |
|---|---|---|---|---|---|---|
| Jsc = short circuit current of cell per square centimeter under 1000 W/m² illumination with AM1.5G spectrum. Voc = open circuit voltage of cell under 1000 W/m² illumination with AM1.5G spectrum. Efficiency = electrical energy output over light energy input measured under 1000 W/m² illumination using AM1.5G at 25°C. FF = Fill Factor, a measure of power out/(Isc*Voc) | | | | | | |

Table 2 reports the average (Av) open circuit voltage, short circuit current (Isc), fill factor and cell efficiency (Eff%) for two groups of cells (85 cells for the wafers from Cz grown silicon, and 94 cells for the wafers from magnetic Cz grown silicon) processed according to Examples 1 and 2 as well as the maximum (max) and minimum (min) values within the group.
The data in Table 2 demonstrates further that the process of this invention produces photovoltaic cells with high efficiency for converting light energy into electric current.

**Table 2**

| | **Voc (V)** | **Isc (A)** | **FF (%)** | **Eff (%)** |
|---|---|---|---|---|
| | Czochralski-grown wafers | | | |
| Av(85) | 0.625 | 5.598 | 80.4 | 18.3 |
| min | 0.618 | 5.495 | 79.2 | 17.7 |
| max | 0.629 | 5.648 | 80.8 | 18.4 |
| | | | | |

| | Magnetic Czochralski-grown wafers | | | |
|---|---|---|---|---|
| Av(94) | 0.627 | 5.530 | 80.4 | 18.1 |
| min | 0.622 | 5.503 | 79.3 | 17.8 |
| max | 0.629 | 5.558 | 80.8 | 18.3 |

Only certain embodiments of the invention have been set forth above. Alternative embodiments and various modifications will be apparent from the above description to those of skill in the art. These and other alternatives are considered equivalents and within the spirit and scope of the present invention.

**Table 3 (Option A)**

| |
|---|
| Step 1- Texturize Both Surfaces of a p-Type Wafer |
| Step 2- Form Emitter Layer on Front Surface of Wafer |
| Step 3- Form Anti-Reflective Coating on Front Surface of Wafer |
| Step 4- Remove Residual Anti-Reflective Coating from Back Surface of Wafer |
| Step 5- Form Protective Layer on Back Surface of Wafer |
| Step 6- Form Grooves in Front Surface of Wafer |
| Step 7- Etch Grooves |
| Step 8- Clean Grooves and Remove Protective Layer and Retain Texture on Back Surface |
| Step 9-Add N-Dopant to Grooves in Front Surface |
| Step 10- Plasma Etch Back Surface of Wafer to Remove N- Dopant |
| Step 11- Deposit P-Type Dopant on Back Surface |
| Step 12- Sinter to Form BSF |
| Step 13- Add Metal to Grooves in Front Surface of Wafer and Form Back Contact |

**Table 4 (Option B)**

| |
|---|
| Step 1- Texturize Both Surfaces of a P-Type Wafer |
| Step 2- Form Emitter Layer on Front Surface of Wafer |
| Step 3- Form Anti-Reflective Coating on Front Surface of Wafer |
| Step 4- Remove Residual Anti-Reflective Coating from Back Surface of Wafer |
| Step 5- Form Grooves in Front Surface of Wafer |
| Step 6- Etch Grooves and Back Surface of Wafer to Form Planar Surface on Back Surface |
| Step 7- Clean Grooves |
| Step 8-Add N-Dopant to Grooves in Front Surface |
| Step 9- Aqueous Etch Only Back Surface of Wafer to Remove N- Dopant and Texturize Back Surface |
| Step 10- Deposit P-Type Dopant on Back Surface |
| Step 11- Sinter to Form BSF |
| Step 12- Add Metal to Grooves in Front Surface of Wafer and Form Back Contact |

**Table 5 (Option C)**

| |
|---|
| Step 1- Texturize Both Surfaces of a P-Type Wafer |
| Step 2- Form Emitter Layer on Front Surface of Wafer |
| Step 3- Form Anti-Reflective Coating on Front Surface of Wafer |
| Step 4- Remove Residual Anti-Reflective Coating from Back Surface of Wafer |
| Step 5- Form Grooves in Front Surface of Wafer |
| Step 6- Etch Grooves Without Etching Rear Surface (One Sided Wet Chemical Etch) - Back Surface Left Textured |
| Step 7- Clean Grooves |
| Step 8-Add N-Dopant to Grooves in Front Surface |
| Step 9- Aqueous Etch Only Back Surface of Wafer to Remove N- Dopant and Back Surface Left Textured |
| Step 10- Deposit P-Type Dopant on Back Surface |
| Step 11- Sinter to Form BSF |
| Step 12- Add Metal to Grooves in Front Surface of Wafer and Form Back Contact |

**Table 6 (Option C')**

| |
|---|
| Step 1- Texturize Both Surfaces of a P-Type Wafer |
| Step 2- Form Emitter Layer on Front Surface of Wafer |
| Step 3- Form Anti-Reflective Coating on Front Surface of Wafer |
| Step 4- Remove Residual Anti-Reflective Coating from Back Surface of Wafer |
| Step 5- Form Grooves in Front Surface of Wafer |
| Step 6- Etch Grooves Using Two-Sided Wet Chemical Etch Leaving Back Surface Textured |
| Step 7- Clean Grooves |
| Step 8-Add N-Dopant to Grooves in Front Surface |
| Step 9- Aqueous Etch Only Back Surface of Wafer to Remove N- Dopant and Back Surface Left Textured |
| Step 10- Deposit P-Type Dopant on Back Surface |
| Step 11- Sinter to Form BSF |
| Step 12- Add Metal to Grooves in Front Surface of Wafer and Form Back Contact |

**Table 7 (Option D)**

| |
|---|
| Step 1- Texturize Both Surfaces of a P-Type Wafer |
| Step 2- Form Emitter Layer on Front Surface of Wafer |
| Step 3- Form Anti-Reflective Coating on Front Surface of Wafer |
| Step 4- Remove Residual Anti-Reflective Coating from Back Surface of Wafer |
| Step 5- Form Protective Layer on Back Surface of Wafer |
| Step 6- Form Grooves in Front Surface of Wafer |
| Step 7- Etch Grooves |
| Step 8- Clean Grooves and Remove Protective Layer and Retain Texture on Back Surface |
| Step 9-Add N-Dopant to Grooves in Front Surface |
| Step 10- Aqueous Etch Only Back Surface of Wafer to Remove N- Dopant and Texturize Back Surface |
| Step 11- Deposit P-Type Dopant on Back Surface |
| Step 12- Sinter to Form BSF |
| Step 13- Add Metal to Grooves in Front Surface of Wafer and Form Back Contact |

**Table 8 (Option E)**

| |
|---|
| Step 1- Texturize Both Surfaces of a P-Type Wafer |
| Step 2- Form Emitter Layer on Front Surface of Wafer |
| Step 3- Form Anti-Reflective Coating on Front Surface of Wafer |
| Step 4- Remove Residual Anti-Reflective Coating from Back Surface of Wafer |
| Step 5- Form Grooves in Front Surface of Wafer |
| Step 6- Etch Grooves Without Etching Rear Surface (One Sided Wet Chemical Etch) - Back Surface Left Textured |
| Step 7- Clean Grooves |
| Step 8-Add N-Dopant to Grooves in Front Surface |
| Step 9- Plasma Etch Back Surface of Wafer to Remove N- Dopant |
| Step 10- Deposit P-Type Dopant on Back Surface |
| Step 11- Sinter to Form BSF |
| Step 12- Add Metal to Grooves in Front Surface of Wafer and Form Back Contact |

**Table 9 (Option E')**

| |
|---|
| Step 1- Texturize Both Surfaces of a P-Type Wafer |
| Step 2- Form Emitter Layer on Front Surface of Wafer |
| Step 3- Form Anti-Reflective Coating on Front Surface of Wafer |
| Step 4- Remove Residual Anti-Reflective Coating from Back Surface of Wafer |
| Step 5- Form Grooves in Front Surface of Wafer |
| Step 6- Etch Grooves Using Two-Sided Wet Chemical Etch Leaving Back Surface Textured |
| Step 7- Clean Grooves |
| Step 8-Add N-Dopant to Grooves in Front Surface |
| Step 9- Plasma Etch Back Surface of Wafer to Remove N- Dopant |
| Step 10- Deposit P-Type Dopant on Back Surface |
| Step 11- Sinter to Form BSF |
| Step 12- Add Metal to Grooves in Front Surface of Wafer and Form Back Contact |

## Claims

1. A process for making a photovoltaic cell comprising:
(a) forming a first layer on a front surface of a semiconductor wafer, the wafer comprising a first dopant and the first layer comprising a dopant of a conductivity type opposite the first dopant;
(b) depositing a surface coating on a front surface of the wafer over the first layer;
(c) forming grooves in the front surface of the wafer after depositing the surface coating thereon;
(d) adding dopant to the grooves of a conductivity type opposite the first dopant;
(e) treating a back surface of the wafer to remove all or substantially all dopant having a conductivity type opposite the first dopant;
(f) forming a back contact over the back surface of the wafer; and
(g) adding an electrically conducting material to the grooves.

2. The process of Claim 1 wherein the wafer comprises silicon and the first dopant is a p-dopant.

3. The process of Claim 1 or Claim 2 further comprising a texturing step to texturize the front surface and back surface of the wafer.

4. The process of Claim 3 wherein texture on the back surface of the wafer is retained in the photovoltaic cell.

5. The process of any one of Claims 1 to 4 wherein the semiconductor wafer is a monocrystalline wafer comprising silicon.

6. The process of any one of Claims 1 to 5 further comprising forming a back surface field.

7. The process of Claim 6 wherein the wafer comprises silicon having p-type conductivity and the forming comprises applying aluminum to the back surface of the wafer and thereafter alloying the aluminum in the silicon wafer.

8. The process of Claim 7 wherein the aluminum is alloyed into the back surface by heating the wafer at a temperature of about 900 °C to about 1050 °C for about 10 to about 60 minutes in an atmosphere containing molecular oxygen gas.

9. The process of any one of Claims 6 to 8 wherein the back surface is etched with a plasma to remove all of substantially all of the dopant having the conductivity type opposite the first dopant.

10. The process of Claim 9 wherein the plasma is formed from a mixture comprising a halocarbon and molecular oxygen.

11. The process of any one of Claims 1 to 10 wherein the dopant added to the grooves comprises phosphorus.

12. The process of Claim 11 wherein the doping comprises heating the wafer in a mixture of phosphorus oxychloride and molecular oxygen gas at a temperature of about 920 °C to about 980 °C for about 30 to about 50 minutes.

13. A process for making a photovoltaic cell comprising:
(a) texturizing a wafer comprising silicon and having a first dopant, a front surface and a back surface, to texturize the front and back surfaces;
(b) forming a first layer on a front surface of the wafer comprising a dopant of a conductivity type opposite the first dopant;
(c) depositing an anti-reflective surface coating on the front surface of the wafer over the first layer;
(d) forming grooves in the front surface of the wafer after depositing the anti-reflective coating thereon;
(e) adding to the grooves and to the back surface a dopant of a conductivity type opposite the first dopant;
(f) treating a back surface of the wafer to remove all or substantially all of the dopant having conductivity type opposite the first dopant;
(g) forming a back surface field;
(h) forming a back contact over the back surface of the wafer; and
(i) adding an electrically conducting material to the grooves.

14. The process of Claim 13 further comprising etching the grooves prior to adding an electrically conducting material.

15. The process of Claim 14 wherein prior to etching the grooves a protective coating is applied to the back surface.

16. The process of Claim 15 wherein the protective coating is silicon dioxide.

17. A photovoltaic cell comprising:
(a) a semiconductor wafer comprising silicon doped with a first dopant, the wafer having a front surface and a back surface;
(b) a first layer comprising a second dopant of a conductivity type opposite to the first dopant positioned over the front surface;
(c) an anti-reflective coating positioned over the front surface;
(d) a front contact buried in the front surface;
(e) a back contact over the back surface; and
(f) a back surface field
wherein the back surface of the wafer is free or substantially free of second dopant.

18. The photovoltaic cell of Claim 17 wherein the back surface of the wafer is free of second dopant.

19. The photovoltaic cell of Claim 17 or Claim 18 wherein the back surface of the wafer is textured.

20. The photovoltaic cell of any one of Claims 17 to 19 wherein the wafer has a p-type conductivity.

21. The photovoltaic cell of any one of Claims 17 to 20 wherein the second dopant comprises phosphorus.

22. The photovoltaic cell of any one of Claims 17 to 21 wherein the buried contact comprises a conductive metal and silicon in the wafer under the metal has a bulk minority lifetime of at least about 20 microseconds.

23. The photovoltaic cell of Claim 22 wherein silicon in the wafer under the metal has a bulk minority lifetime of at least about 50 microseconds.

24. The photovoltaic cell of Claim 21 wherein silicon in the wafer under the metal has a bulk minority lifetime of at least about 100 microseconds.
